# EUROPEAN PATENT SPECIFICATION

(11) **EP 0 496 586 B1**
(45) Date of publication and mention of the grant of the patent: **10.01.1996**
(21) Application number: 92300514.4
(22) Date of filing: 21.01.1992
(51) Int. Cl.: H05K 13/02

(54) **Chip-type electronic element supplying apparatus**
Zuführapparat für chipartige elektronische Bauelemente
Appareil d'alimentation pour élément électronique de type chip

(30) Priority: 22.01.1991 JP 5692/91
(43) Date of publication of application: 29.07.1992
(73) Proprietor: MATSUSHITA ELECTRIC INDUSTRIAL CO., LTD., Kadoma-shi, Osaka-fu, 571 (JP)
(72) Inventor: Fujiwara, Hiroyuki, Minamikawachi-gun, Osaka-fu (JP); Fujita, Takayuki, Hirakata-shi (JP); Negishi, Shigetoshi, Suita-shi (JP); Tanaka, Kunio, Kadoma-shi (JP); Terazawa, Hiroaki, Fukushima-ku, Osaka-shi (JP); Nakamura, Hidekazu, Ibaraki-shi (JP); Kado, Takayoshi, Katano-shi (JP)
(74) Representative: Sorrell, Terence Gordon

(56) References cited:
- EP-A- 0 013 979
- EP-A- 0 277 732
- DE-A- 2 949 196
- GB-A- 2 169 262
- US-A- 4 620 655

## Description

The present invention relates to a chip-type electronic element supplying apparatus for use in an apparatus for automatically mounting chip-type electronic elements on a printed circuit board.

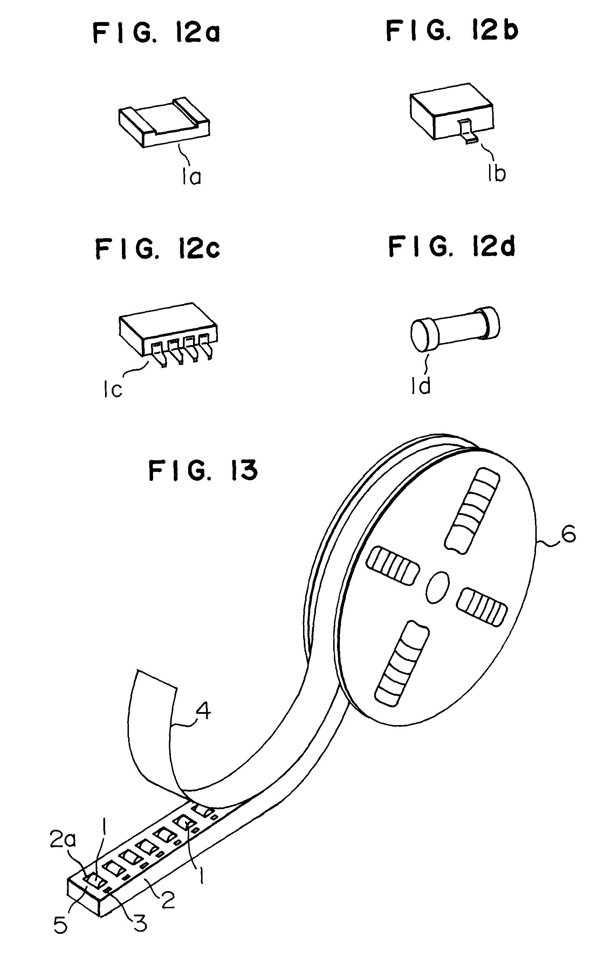

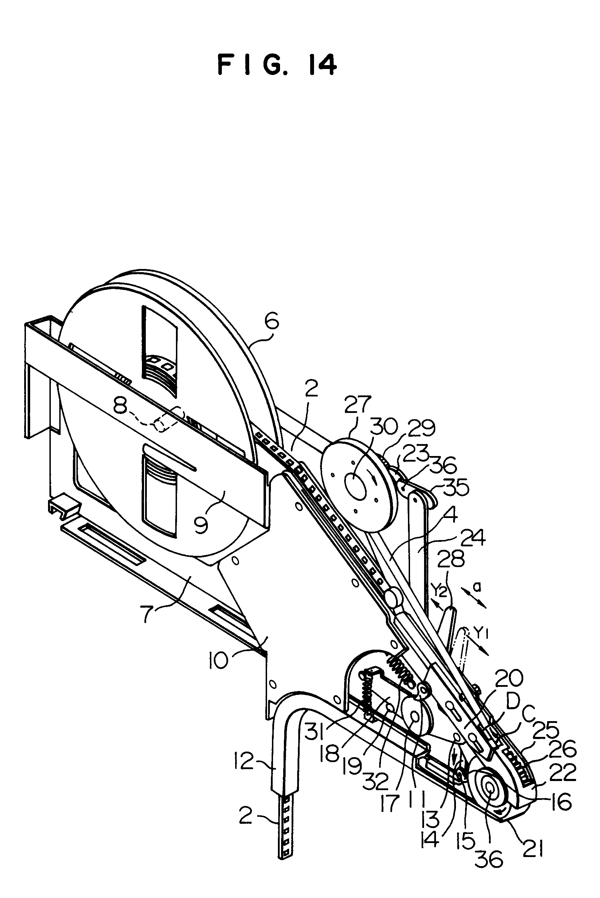

Chip-type electronic elements la formed variously as shown in Figs. 12a to 12d are accommodated in recessed portions 2a formed in a carrier tape 2 which has conveyance holes 3 formed at predetermined intervals on either side of the carrier tape 2 as shown in Fig. 13. Thus, a taped electronic element group 5 is supplied to a user in a state where it is covered with a cover tape 4 and wound around a reel 6. The apparatus (omitted from illustration) for automatically mounting electronic elements is arranged to sequentially remove the chip-type electronic elements 1 from the reel 6 so that they can then be mounted on a circuit board. The chip-type electronic element supplying apparatus is a portion of the above-described apparatus is automatically mounting electronic elements.

Fig. 14 is a perspective vie of a known chip-type electronic element supplying apparatus. Referring to Fig. 14, a carrier tape 2 taken out from the above-described reel 6 is guided to a feeding ratchet 25 so that a multiplicity of claws 26 of the feeding ratchet 25 sequentially engage conveyance holes 3 in the carrier tape 2 when the feeding ratchet 25 is rotated. The carrier tape 2 is conveyed while being guided over the feeding ratchet 25 by a tape retainer 22 disposed above said feeding ratchet 25. The above-described cover tape 4 is turned by an angle of about 180° and taken out in a direction opposite to the direction in which the carrier tape 2 is fed, at a position of a slit D formed slightly upstream of an open portion C in the tape retainer 22 and through which the electronic elements are removed, so that the cover tape 4 is separated from its carrier tape 2. A leading portion of the separated cover tape 4 is wound around a take-up reel 27.

The open portion C through which the electronic elements are removed is open when a shutter 20 is moved in a direction designated by arrow Y₂, which is opposite to a direction designated by arrow Y₁, by means of a reverse-rotation lever 11 disposed between a feeding lever 28 and the shutter 20 under the action of a kicker (omitted from illustration) provided for the apparatus (omitted from illustration) for automatically mounting electronic elements. The shutter 20 is movably fastened to the tape retainer 22 in such a manner that the shutter 20 uncovers the opening C through which the electronic elements are removed when the feeding lever 28 is pulled in the direction Y₂ by a tension spring 32.

A feeding ratchet lever 14 connected to the above-described feeding lever 28 by a connection pin 13 and arranged to act in synchronisation with the action of the feeding lever 28 can be moved downwards. As a result, a feeding ratchet claw 16 fastened to the feeding ratchet lever 14 via a supporting point 15 is returned by one pitch in a direction which opposes a direction of rotation of the feeding ratchet 25.

When the above-described feeding lever 28 is moved in the direction Y₁, a movable lever 18 having a supporting shaft 17 which is employed as the supporting shaft for the feeding lever 28 is moved upwards via a connection pin 19. Then, a take-up ratchet lever 35 is moved upwards around a rotational shaft 30 of a take-up reel 27 by a connection rod 24 which establishes a connection between the movable lever 18 and the take-up ratchet lever 35. As a result, a take-up ratchet claw 23 fastened to the ratchet lever 35 via a supporting point 36 is returned by one or several pitches in a direction which opposes a direction of rotation of the take-up ratchet 29.

In the above-described state in which the open portion C through which electronic elements are removed is opened, an operation of lifting the electronic elements and an operation of mounting them on a printed circuit board (omitted from illustration) are performed by a vacuum lifting head (also omitted from illustration) . Since this process is not relevant to the structure of the chip-type electronic element supplying apparatus, it is not described here.

When the pushing force applied to the feeding lever 28 from the abovementioned kicker is released as shown in Fig. 14, the feeding lever 28 is returned in the direction Y₂ by the urging force of the tension spring 32. As a result, the feeding ratchet lever 14 is moved upwards and the feeding ratchet claw 26 pushes the feeding ratchet 25 upwards in synchronisation with the upward movement of the feeding ratchet lever 14 to rotate it by a predetermined number of pitches in the tape feeding direction. Then, the claws 26 secured to the feeding ratchet 25 convey the carrier tape 2 by a predetermined number of pitches in the direction Y₁. At this time, the shutter 20 is, similarly to the carrier tape 2, moved in the direction Y₁ by means of the reverse-rotation lever 11. As a result, a state in which the open portion C is covered by the shutter 20 is achieved. Therefore, the carrier tape 2 is moved with the electronic elements 1 being covered by the shutter 20. As a result, undesirable pop-out of the chip-type electronic elements 1 from the recessed portions 2a of the carrier tape 2 can be prevented.

On the other hand, the feeding ratchet 29 is rotated in a direction designated by an arrow shown in Fig. 14 by the take-up ratchet claw 23 on return of the feeding lever 28. The cover tape 4 separated from the carrier tape 2 at the slit D is wound onto the take-up reel 27 by a predetermined length (a length corresponding to a predetermined pitch of feeding of the carrier tape 2). At this time, the movable lever 18 is moved downwards on return of the feeding lever 28 in the direction Y₂. During the above-described movement process, the movable lever 18 is given the urging force determined by the tension spring so as to keep an interval from the connection pin 19.

As described above, the structure is arranged such that a predetermined rotational force is applied to the take-up reel 27 by the tension spring 31 via the connection rod 24, the feeding ratchet claw 23 and the feeding ratchet 29.

Furthermore, the reel 6 is inserted onto the supporting shaft 8 provided in the body cover 7 and is held by a leaf spring 9 acting on a side surface thereof. Therefore, horizontal deviation of the reel 6 is prevented and the reel 6 is stably held so that looseness in the carrier tape 2 at the time of feeding is also prevented. Reference numeral 10 represents a front cover, 21 represents a carrier tape receiving plate and 12 represents a carrier tape discharge port.

Recently, there has been a desire to reduce (in particular, to reduce the space between supply apparatii) the thickness of the chip-type electronic element supplying apparatus in order to improve the mounting ability of the apparatus for automatically mounting electronic elements. Therefore, the known chip-type electronic element supplying apparatus as shown in Fig. 14 poses a problem in reducing its thickness due to the unsatisfactory rigidity of the body thereof and thus the electronic elements cannot be stably supplied.

Applicant's own European application No. 80100335.1, published as EP-A-0013979, describes a chip-type electronic element supplying apparatus comprising: a body frame; a reel on which is wound a taped electronic element group consisting of a carrier tape having accommodating portions at predetermined intervals for receiving chip-type electronic elements and a cover tape applied on said carrier tape so as to cover said electronic elements received in the accommodating portions; and a reel side plate disposed at an end portion of said body frame, said reel being rotatably fastened thereto.

Another chip-type electronic element supplying apparatus is known from United Kingdom patent specification GB 2169262A. This apparatus includes a recessed portion formed in another end portion of said body frame incorporating therein a tape feeding mechanism having a feeding claw for intermittently feeding a carrier tape; a tape guide disposed above said feeding mechanism having a slit formed therein through which a cover tape peeled from said carrier tape can be drawn out of the recessed portion for winding on a take-up reel, and an electronic element take-out portion 83 through which said electronic elements can be successively removed from said carrier tape, this being formed in a front end part of said tape guide.

An object of the present invention is to provide a chip-type electronic element supplying apparatus capable of overcoming the above-described problems of the prior art and which is capable of improving the maintaining of electronic elements.

In order to achieve the above-described object, according to the present invention there is provided a chip-type electronic element supplying apparatus comprising: a body frame; a reel on which is wound a taped electronic element group of the type consisting of a carrier tape having accommodating portions at predetermined intervals for receiving chip-type electronic elements and a cover tape applied on said carrier tape to cover said electronic elements received in the accommodating portions; and a reel side plate disposed at an end portion of said body frame, said reel being rotatably fastened thereto, characterised in that the apparatus includes at least one other reel on wich another taped electronic element group of said type is wound, said reel being rotatably fastened to said reel side plate, said reel side plate having a stepped portion such that the reels fastened to it are deviated by an amount corresponding to a width of said carrier tape; a recessed portion formed in another end portion of said body frame incorporating therein tape feeding mechanisms of a number equal to that of the reels and each having a feeding claw for intermittently feeding an associated taped electronic element group; a separating plate fixed to said body frame (40) for separating said taped electronic element groups supplied from said reels from one another when said taped electronic element groups are fed by said tape feeding mechanisms; tape retainers disposed above said feeding mechanisms, each tape retainer having a slit formed therein through which a cover tape peeled from its carrier tape can be drawn out from the recessed portion for winding on take-up reels which are located on an upper portion of said separating plate ; and electronic element take-out portions 83 through which said electronic elements can be successively removed from said carrier tapes, the take-out portions being formed respectively in front end parts of said tape retainers.

As a result of the above-described structure, the necessity of reducing the thickness of the chip-type electronic element supplying apparatus can be eliminated and thereby the rigidity of the body frame can be maintained satisfactorily strong, enabling mounting ability to be improved.

Other and further objects, features and advantages of the invention will be more readily understood from the following description with reference to the drawings, of which:-
Fig. 1 is a perspective view which illustrates a chip-type electronic element supplying apparatus according to the present invention;
Fig. 2 is an enlarged perspective view which illustrates portion of the apparatus of Fig. 1;
Fig. 3 is a front elevational view which illustrates the portion of Fig. 2;
Fig. 4 is a schematic view which illustrates another embodiment of the present invention;
Fig. 5 is a schematic view which illustrates another embodiment of the present invention;
Fig. 6 is a schematic view which illustrates another embodiment of the present invention;
Fig. 7 is a plain layout view which illustrates the arrangement of reels according to another embodiment of the present invention;
Fig. 8 is a plain layout view which illustrates the arrangement of reels according to another embodiment of the present invention;
Fig. 9 is a schematic view which illustrates another embodiment of the present invention;
Fig. 10 is a plan view which illustrates the width of the apparatus according to the present invention;
Fig. 11 is a plan view which illustrates a conventional dual-type apparatus;
Figs. 12a to Fig. 12d are perspective views which illustrate various chip-type electronic elements;
Fig. 13 is a perspective view which illustrates a state in which the chip-type electronic elements are covered with a tape; and
Fig. 14 is a perspective view which illustrates a conventional chip-type electronic element supplying apparatus.

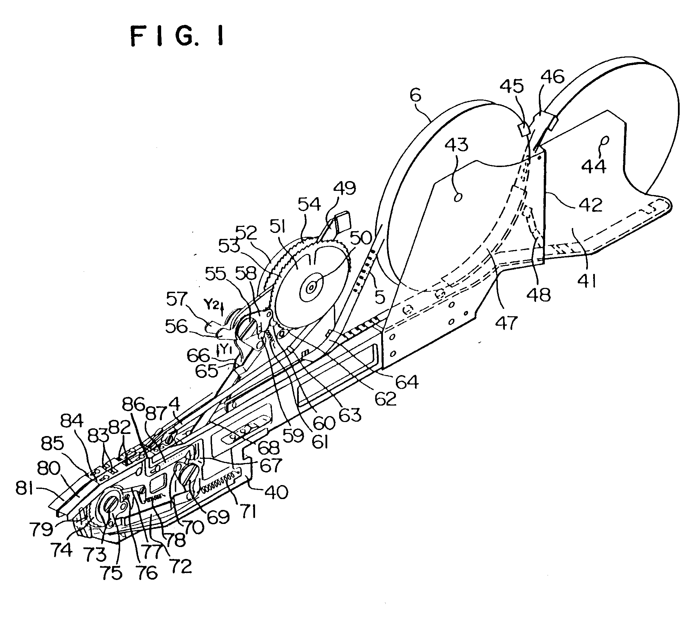

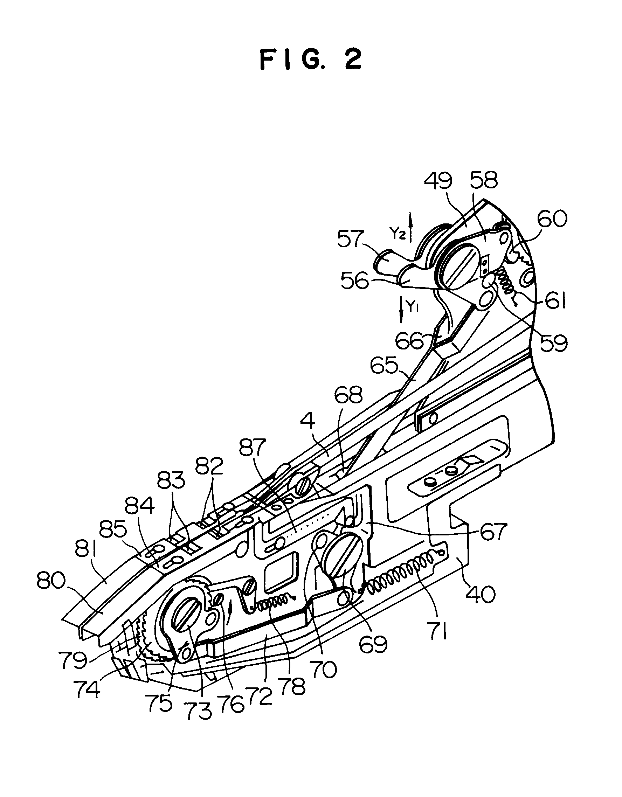

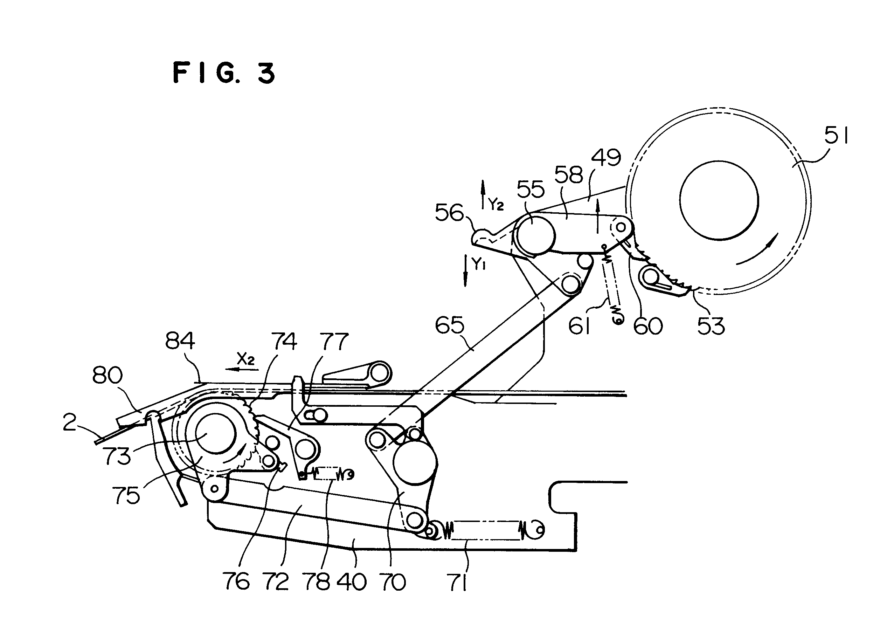

Preferred embodiments of the present invention will now be described. Fig. 1 is a perspective view which illustrates an embodiment of a chip-type electronic element supplying apparatus according to the present invention. Fig. 2 is an enlarged perspective view which illustrates portion of this apparatus and Fig. 3 is a front elevational view illustrating the same portion. Since the structure is arranged in such a manner that a taped electronic group 5, formed by accommodating chip-type electronic elements 1 in recessed portions 2a of a carrier tape 2 before being sealed by a cover tape 4 and wound around a reel 6, is the same as used with the above-described known structure, the same reference numerals will be used in and specific descriptions thereof will be omitted from the following description.

Referring to Figs. 1 to 3, a reel side plate 41 is fastened to an end portion of a body frame 40 which is made of aluminium alloy or the like. The reel side plate 41 has a size which enables two reels 6 to be fastened in its longitudinal direction. Furthermore, the reel side plate 41 has a stepped portion 42 for the purpose of fastening front and the rear reels 6 while deviating them by an amount corresponding to the width of a carrier tape 2. Furthermore, reel shafts 43 and 44 are secured to the reel side plate 41 so that the reels 6 are rotatably fastened to the reel shafts 43 and 44. In addition, reel retainers 45 and 46 for holding corresponding outer surfaces of the reels 6 respectively fastened to the reel shafts 43 and 44 are disposed in an upper portion of an intermediate portion of the reel side plate 41. Furthermore, tape guide plates 47 and 48, each of which is formed into a shape to suit the outer surface of a reel 6, are disposed in a lower portion of the intermediate portion of the reel side plate 41.

Furthermore, a separation plate 49 which halves the width of the body frame 40 is fastened to a top surface of an intermediate portion of the body frame 40. In addition, a reel shaft 50 is disposed in an upper portion of the separation plate 49 in such a manner that the reel shaft 50 extends through the separation plate 49. Furthermore, two take-up reels 51 and 52 are rotatably fastened to two end portions of the reel shaft 50 in such a manner that the two take-up reels 51 and 52 enclose the separation plate 49. Each of the above-described take-up reels 51 and 52 has a large flange adjacent to the separation plate 49 so as to respectively form take-up ratchets 53 and 54 each having a gear portion formed on an outer surface of a respective flange.

In addition, a supporting shaft 55 is disposed in the upper portion of the separation plate 49, the supporting shaft 55 holding two drive levers 56,57 and two take-up ratchet levers 58 which are pivotally fastened in such a manner that they enclose therebetween the separation plate 49. The drive levers 56,57, and the take-up ratchet levers 58 are arranged to act in association with one another about a connection pin 59. Furthermore, a feeding ratchet claw 60 is connected to a front portion of each of the take-up ratchet levers 58, the feeding ratchet claws 60 being connected to the take-up ratchets 53 and 54 of the take-up reels 51 and 52. In addition, a tension spring 61 is arranged between the take-up ratchet levers 58, the tension spring 61 acts to rotate the drive levers 56 or 57 in a direction designated by an arrow Y₂ when the drive levers 56 or 57 are rotated in a direction designated by an arrow Y₁.

Furthermore, reverse-rotation protection claws 62 are disposed on the two sides of the above-described separation plate 49, the reverse-rotation protection claws 62 always being in engagement with the take-up ratchets 53 and 54 to check reverse rotation of the take-up reels 51 and 52. In addition, cover tape guide rollers 63 are disposed on both sides of an intermediate portion of the separation plate 49, the cover tape guide rollers 63 acting to guide the cover tapes 4. Furthermore, a guide plate 64 is disposed on either side of the lower portion of the separation plate 49, the guide plates 64 acting to guide the taped electronic groups 5 drawn out from the reels 6.

In addition, connection members 65 and 66 are respectively connected to the above-described drive levers 56 and 57, the connection members 65 and 66 extending to a recessed portion 67 formed in a front portion of the body frame 40. The connection members 65 and 66 pass through a slit 68 formed in a central portion of a top surface of the body frame 40 prior to leading portions thereof extending into the recessed portion 67. The leading portions are connected to end portions of right and left reverse-rotation levers 70 rotatably fastened to a support shaft 69. A tension spring 71 is arranged between the reverse-rotation levers 70, the tension spring 71 acting to rotate the reverse-rotation levers 70 after they have been rotated by rotation of the drive levers 56 and 57 transmitted via the connection members 65 and 66. Furthermore, a connection lever 72 is connected to each reverse-rotation lever 70. A front portion of the connection lever 72 is connected to a feeding ratchet lever 75 positioned in the recessed portion 67 and together with a feeding ratchet 74 rotatably fastened to a supporting shaft 73. The feeding ratchet lever 75 has a ratchet claw 76 which engages with the feeding ratchet 74 and acts to intermittently rotate said ratchet 74. Furthermore, a reverse-rotation prevention lever 77 is disposed on another surface of the feeding ratchet 74 in such a manner that it is always in engagement with the feeding ratchet 74 under an urging force provided by a spring 78.

In addition, a carrier tape feeding ratchet wheel 79 is integrally formed with the above-described feeding ratchet 74 in such a manner that a portion of it projects over a top surface of the leading portion of the body frame 40 such that it engages conveyance holes 3 in the carrier tape 2 to convey the carrier tape 2. Tape retainers 80 and 81 are fastened to the top surface of the leading portion of the body frame 40, the tape retainers 80 and 81 acting to guide the taped electronic element groups 5 respectively supplied from the reels 6 after they are separated from each other by the separation plate 49 such that they engage with respective carrier tape feeding ratchet wheels 79. Each of the tape retainers 80 and 81 has a slit 82 and an open portion 83 to allow removal of the cover tapes 4 separated from the carrier tapes 2 through said slits 82 before being guided by their respective cover tape guide rollers 63. As a result, the cover tapes 4 are wound around the take-up reels 51 and 52.

The open portions 83 respectively formed in the tape retainers 80 and 81 in front of the slits 82 serve as portions through which the chip-type electronical elements 1 accommodated in the recessed portion 2a of the carrier tape 2 can be removed by a lifting nozzle fastened to an electronic-element fastening apparatus. Shutters 84 and 85 are movably disposed on the top surfaces of the tape retainers 80 and 81, the shutters 84 and 85 respectively having a fastening cut portion 86 at a position beyond the width of a respective carrier tape 2 and fastened to a leading portion of a connection plate 87 connected to a reverse-rotation lever 70. As a result, the open portions 83 formed in the tape retainers 80 and 81 are covered when the carrier tapes 2 are conveyed by the carrier tape feeding ratchet wheels 79. Therefore, undesirable ejection of the chip-type electronic elements 1 from the recessed portions 2a formed in the carrier tapes 2 is prevented.

The operation of the apparatus thus constituted will now be described.

Firstly, the reels 6 are rotatably fastened to the reel shafts 43 and 44 which are fastened to the reel side plate 41 secured to the end portion of the body frame 40 in the longitudinal direction with respect to the carrier tape supply direction. In order to feed the taped electronic groups 5 wound around the reels 6 by a predetermined quantity, the conveyance holes 3 formed in the carrier tapes 2 engage the carrier tape feeding ratchet wheels 79. The feeding ratchet levers 75 for driving the feeding ratchet claws 76 which engage the feeding ratchets 74 formed integrally with the carrier tape feeding ratchet wheels 79 are driven via the reverse-rotation levers 70 and the connection levers 72 when the drive levers 56 and 57 are driven by an electronic-element automatic fastening apparatus because the connection members 65 and 66 are thus operated. When the drive levers 56 and 57 are rotated in the direction Y₁, the feeding claws 76 are returned by one pitch in a direction opposite to the feeding direction. When the ratchet feeding claws 76 then engage positions between the teeth of the feeding ratchets 74, the carrier tapes 2 are fed by a predetermined pitch under the action of the tension spring 71. In association with the above-described sequential feeding mechanism, the cover tapes 4 are turned by an angle of about 180° and taken out in a direction opposite to the direction in which the carrier tapes 2 are fed, at the position of the slits 82 positioned slightly upstream of the open portions 83 through which the electronic elements are removed. Then, the cover tapes 4 are separated from the carrier tapes 2 before they are wound around the take-up reels 51 and 52. When the above-described drive levers 56 and 57 are moved in the direction Y₁, the ratchet levers 58 having the same supporting shaft 55 as that of the drive levers 56 and 57 are moved upwards via the connection pin 59 secured to the drive levers 56 and 57. Thus, the ratchet levers 58 are returned by one or several pitches in the reverse direction. Furthermore, when the drive levers 56 and 57 are returned in the direction Y₂ by the tension spring 71, the take-up reels 51 and 52 are rotated in a winding direction simultaneously with the sequential feeding of the carrier tapes 2. The structure is arranged in such a manner that one body frame 40 has two systems each of which is composed of the above-described sequential mechanism, the two sequential mechanisms opposing each other with respect to a fastening surface formed between the two carrier tapes 2.

When the carrier tapes 2 are fed by the feeding ratchets 74, the shutters 84 and 85 disposed on the top surfaces of the two tape retainers 80 and 81 fastened to the body frame 40 are connected to the above-described drive levers 56 and 57 by the reverse levers 70 and the connection plates 87. As a result, the open portions 83 through which the electronic elements are removed are covered and the carrier tapes 2 are fed by a predetermined pitch amount in a state where the chip-type electronic elements 1 are covered by the shutters 84 and 85. Therefore, undesirable pop-out of the chip-type electronic elements 1 from the recessed portions 2a formed in the carrier tapes 2 can be prevented. Furthermore, the fastening cut portions 86 are formed in the surfaces of each of the shutters 84 and 85 to be deviated from the width of the carrier tape 2. The leading portions of the above-described connection plates 87 are inserted into the respective fastening cut portions 86 and the shutters 84 and 85 are thereby driven. Therefore, the width of the shutter mechanism can be reduced.

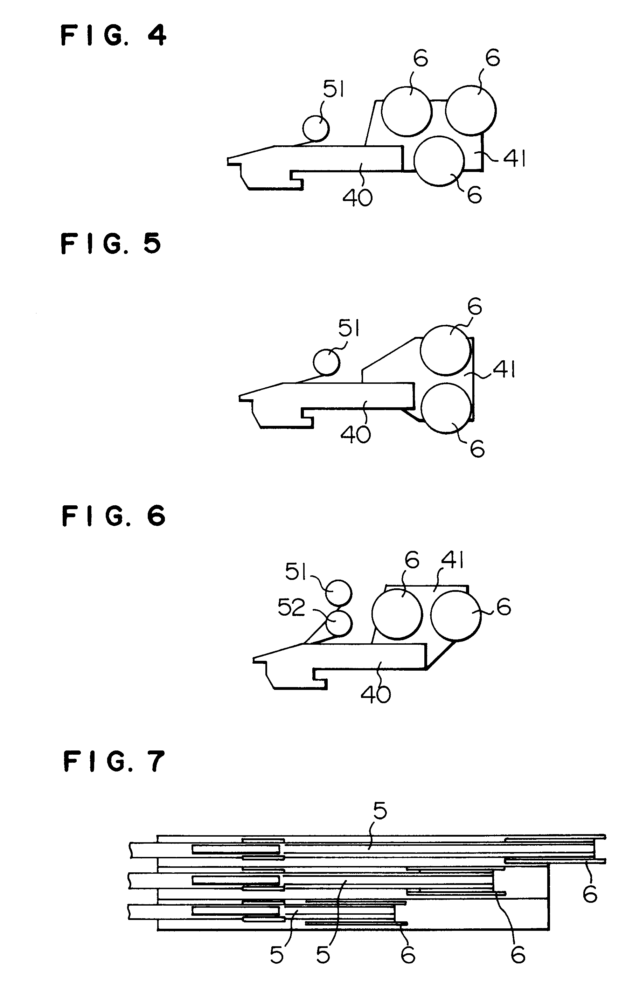

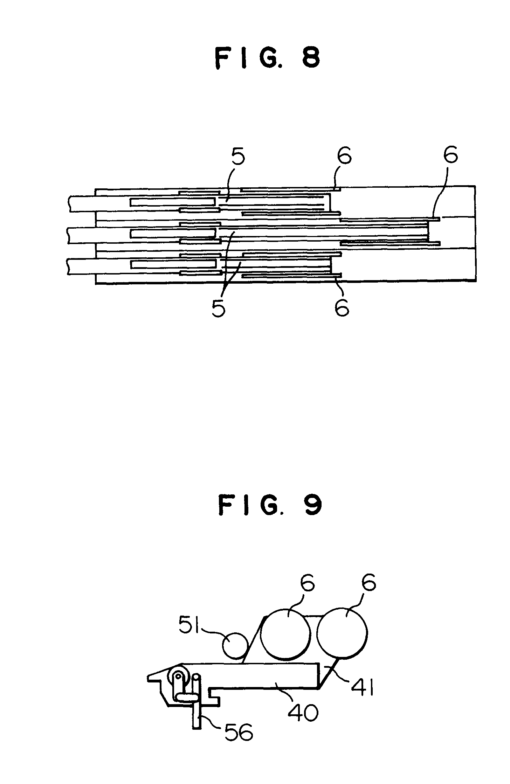

A variety of modifications to the above-described embodiment may be employed. The reels 6 may be disposed as shown in Fig. 4 in such a manner that two reels 6 are longitudinally disposed and another reel is disposed below the two reels 6. Another structure as shown in Fig. 5 may be employed in which two reels 6 are disposed vertically. A structure as shown in Fig. 6 may be employed in which the take-up reels 51 and 52 are vertically disposed. Other structures as shown in Figs. 7 and 8 may be employed in each of which a plurality of reels 6 are disposed in parallel with respect to the supply direction. In addition, a structure as shown in Fig. 9 may be employed in which the drive levers 56 and 57 are disposed adjacent to the recessed portion 67 formed in the body frame 40.

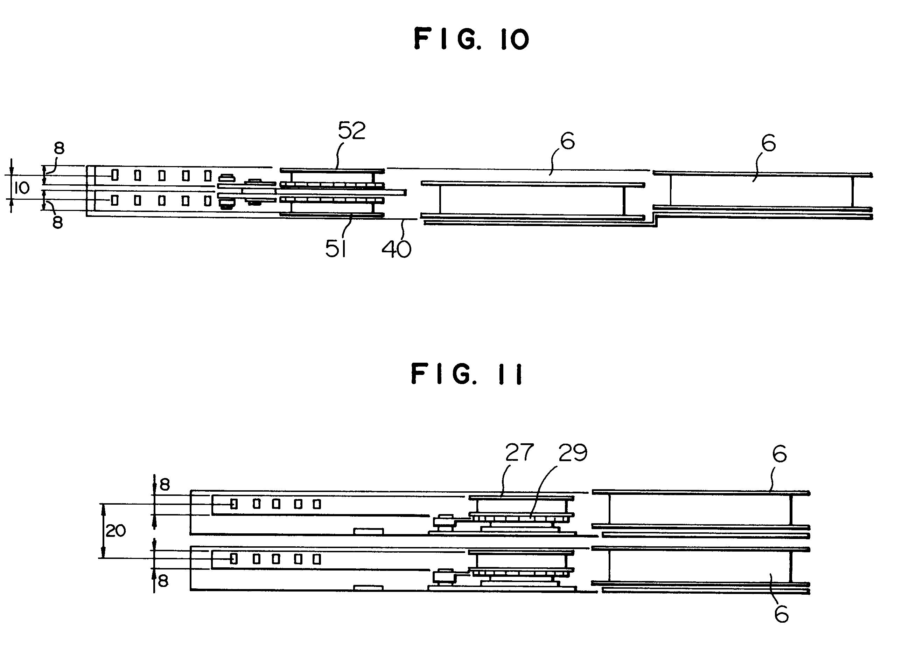

As described above, according to the present invention, a chip-type electronic element supplying apparatus can be constricted to make its width, as shown in Fig. 10, substantially the same as the width of the afore-described known chip-type electronic element supply apparatus. Therefore, many and various chip-type electronic elements 1 can be supplied when the structure according to the present invention is used while being combined with the apparatus for automatically mounting electronic-elements.

As described above, the chip-type electronic element supplying apparatus according to the present invention enables an effect to be obtained in that a limited pitch (10 mm) can be achieved which is half of that achieved by the known chip-type electronic element supplying apparatus. Therefore, an improved chip-type electronic element supplying apparatus in which the mounting ability of an automatic mounting apparatus of which it forms part can be provided. Therefore, the apparatus according to the present invention is expected to be used widely in the industrial field and thereby a significant advantage will be obtained.

## Claims

1. A chip-type electronic element supplying apparatus comprising: a body frame (40); a reel (6) on which is wound a taped electronic element group (5) of the type consisting of a carrier tape (2) having accommodating portions (2a) at predetermined intervals for receiving chip-type electronic elements (1) and a cover tape (4) applied on said carrier tape (2) to cover said electronic elements (1) received in the accommodating portions (2a); and a reel side plate (41) disposed at an end portion of said body frame (40), said reel (6) being rotatably fastened thereto, characterised in that the apparatus includes at least one other reel (6) on which another taped electronic element group of said type is wound, said reel being rotatably fastened to said reel side plate (41), said reel side plate (41) having a stepped portion (42) such that the reels (6) fastened to it are deviated by an amount corresponding to a width of said carrier tape (2); a recessed portion (67) formed in another end portion of said body frame (40) incorporating therein tape feeding mechanisms (70,72,74,75) of a number equal to that of the reels (6) and each having a feeding claw (79) for intermittently feeding an associated taped electronic element goup (2); a separating plate (49) fixed to said body frame (40) for separating said taped electronic element groups supplied from said reels (2) from one another when said taped electronic element groups (2) are fed by said tape feeding mechanisms (70,72,74,75); tape retainers (80,81) disposed above said feeding mechanisms, each tape retainer (80,81) having a slit 82 formed therein through which a cover tape (4) peeled from its carrier tape (2) can be drawn out from the recessed portion (67) for winding on take-up reels (51,52) which are located on an upper portion of said separating plate (49) ; and electronic element take-out portions 83 through which said electronic elements (1) can be successively removed from said carrier tapes (2), the take-out portions (83) being formed respectively in front end parts of said tape retainers (80,81).

2. A chip-type electronic element supplying apparatus according to claim 1, characterised in that drive levers (56,57) for driving said feeding mechanisms (70,72,74,75) are disposed within the width of a respective taped element group (5) at an intermediate portion of said body frame (40).

3. A chip-type electronic element supplying apparatus according to claim 1 or claim 2, characterised in that outer portions of the take-up reels (51,52) are formed to provide take-up ratchets (53,54).

4. A chip-type electronic element supplying apparatus according to claim 3, characterised in that a drive mechanism (56,57,58,59,60,61) for a take-up ratchet (53,54) composed of a flange of a take-up reel (51,52) is disposed within the width of said take-up reel (51,52).

5. A chip-type electronic element supplying apparatus according to claim 1, characterised in that a connection plate (87) for shutters (84,85) for opening/closing open portions (83) of element take-out portions are fastened to said tape retainers (80,81) at positions deviated from the width of said carrier tapes (2) for said taped electronic elements (1).

## Patentansprüche

1. Zuführapparat für chipartige elektronische Bauelemente mit: einem Aufbaurahmen (40); einer Spule (6), auf der eine gegurtete Gruppe von elektronischen Bauelementen (5) der Art bestehend aus einem Trägergurt (2) mit Unterbringungsbereichen (2a) in vorbestimmten Abständen zur Aufnahme chipartiger elektronischer Bauelemente (1) und einem auf dem Trägergurt (2) aufgebrachten Abdeckgurt (4) zur Abdeckung der in den Unterbringungsbereichen (2a) aufgenommenen elektronischen Bauelemente (1) aufgewickelt ist; und einer an einem Endbereich des Aufbaurahmens (40) angebrachten Spulenseitenplatte (41), wobei die Spule (6) daran drehbar befestigt ist, dadurch gekennzeichnet, daß der Apparat mindestens eine weitere Spule (6), auf der eine weitere gegurtete Gruppe von elektronischen Bauelementen dieser Art aufgewickelt ist, aufweist, wobei die Spule drehbar an der Spulenseitenplatte (41) befestigt ist, wobei die Spulenseitenplatte (41) einen derart gestuften Bereich (42) besitzt, daß die daran befestigten Spulen (6) um ein der Breite des Trägergurtes (2) entsprechendes Stück versetzt sind; einen in einem anderen Endbereich des Aufbaurahmens (40) ausgebildeten ausgenommenen Bereich (67), in dem eine der Anzahl der Spulen (6) gleiche Anzahl von Bandvorschubmechanismen (70, 72, 74, 75) aufgenommen ist, von denen jeder eine Vorschubklaue (79) zum intermittierenden Vorschub einer zugeordneten gegurteten Gruppe elektronischer Bauelemente (2) besitzt; eine an dem Aufbaurahmen (40) befestigte Trennungsplatte (49) zur Trennung der von den Spulen gelieferten gegurteten Gruppen elektronischer Bauelemente (2) voneinander, wenn die gegurteten Gruppen elektronischer Bauelemente (2) durch die Bandvorschubmechanismen (70, 72, 74, 75) vorgeschoben werden; über den Vorschubmechanismen angebrachte Gurtfesthalter (80, 81), von denen jeder einen darin ausgebildeten Schlitz (82) aufweist, durch den ein von seinem Trägergurt (2) abgelöster Abdeckgurt (4) aus dem ausgenommenen Bereich (67) zum Aufwickeln auf Aufnahmespulen (51, 52), die sich auf einem oberen Bereich der Trennungsplatte (49) befinden, herausgezogen werden kann; und Herausnahmebereiche (83) für elektronische Bauelemente, durch die die elektronischen Bauelemente (1) der Reihe nach von den Trägergurten (2) entfernt werden können, wobei die Herausnahmebereiche (83) jeweils in den Vorderendbereichen der Bandfesthalter (80, 81) ausgebildet sind.

2. Zuführapparat für chipartige elektronische Bauelemente nach Anspruch 1, dadurch gekennzeichnet, daß Antriebshebel (56, 57) zum Antrieb der Vorschubmechanismen (70, 72, 74, 75) innerhalb der Breite einer jeweiligen gegurteten Gruppe elektronischer Bauelemente (5) in einem Mittelbereich des Aufbaurahmens (40) angeordnet sind.

3. Zuführapparat für chipartige elektronische Bauelemente nach Anspruch 1 oder Anspruch 2, dadurch gekennzeichnet, daß die äußeren Bereiche der Aufnahmespulen (51, 52) zur Schaffung von Aufnahmeratschen (53, 54) ausgebildet sind.

4. Zuführapparat für chipartige elektronische Bauelemente nach Anspruch 3, dadurch gekennzeichnet, daß ein Antriebsmechanismus (56, 57, 58, 59, 60, 61) für eine von einem Flansch einer Aufnahmespule (51, 52) gebildete Aufnahmeratsche (53, 54) innerhalb der Breite der Aufnahmespule (51, 52) angeordnet ist.

5. Zuführapparat für chipartige elektronische Bauelemente nach Anspruch 1, dadurch gekennzeichnet, daß Verbindungsplatten (87) für Verschlüsse (84, 85) zum Öffnen/Schließen offener Bereiche (83) von Herausnahmebereichen für Elemente an den Gurtfesthaltern (80, 81) an gegenüber der Breite der Trägergurte (2) für die gegurteten elektronischen Elemente (1) versetzten Stellen befestigt sind.

## Revendications

1. Appareil d'alimentation en composants électroniques de type puce, comportant:
un châssis (40) formant corps, une bobine (6) sur laquelle est enroulé un groupe de composants électroniques conditionnés en ruban (5) du type constitué d'un ruban transporteur (2) comportant des parties réceptrices (2a) situées au niveau d'intervalles prédéterminés, destinées à recevoir des composants électroniques (1) de type puce, et d'un ruban de recouvrement (4) appliqué sur ledit ruban transporteur (2) pour recouvrir lesdits composants électroniques (1) reçus dans les parties réceptrices (2a), et une plaque latérale (41) pour bobine disposée au niveau d'une partie d'extrémité dudit châssis (40) formant corps, ladite bobine (6) étant fixée à celle-ci tout en étant libre de tourner, caractérisé en ce que l'appareil comporte au moins une autre bobine (6) sur laquelle est enroulé un autre groupe de composants électroniques conditionnés en ruban du type mentionné, ladite bobine étant fixée à ladite plaque latérale (41) pour bobine tout en étant libre de tourner, ladite plaque latérale (41) pour bobine ayant une partie (42) en forme de marche, de telle sorte que les bobines (6) fixées à celle-ci soient déviées d'une quantité correspondant à une largeur dudit ruban transporteur (2), une partie évidée (67) formée dans une autre partie d'extrémité dudit châssis (40) formant corps comportant des mécanismes d'alimentation en ruban (70, 72, 74, 75), agencés en un nombre égal à celui des bobines (6), et ayant chacun une mâchoire d'alimentation (79) pour fournir de manière intermittente un groupe associé de composants électroniques conditionnés en ruban (2), une plaque de séparation (49) fixée audit châssis (40) formant corps pour séparer lesdits groupes de composants électroniques conditionnés en ruban (2) qui sont fournis à partir desdites bobines lorsque lesdits groupes de composants électroniques conditionnés en ruban (2) sont fournis par lesdits mécanismes d'alimentation en ruban (70, 72, 74, 75), des dispositifs de retenue pour ruban (80, 81) disposés au-dessus desdits mécanismes d'alimentation, chaque dispositif de retenue pour ruban (80, 81) comportant une fente (82), formée dans celui-ci, à travers laquelle un ruban de recouvrement (4), détaché de son ruban transporteur (2), peut être tiré à partir de la partie évidée (67) pour être enroulé sur des bobines réceptrices (51, 52) qui sont positionnées sur une partie supérieure de ladite plaque de séparation (49), et des parties d'extraction de composants électroniques (83) à travers lesquelles lesdits composants électroniques (1) peuvent être successivement récupérés à partir desdits rubans transporteurs (2), les parties d'extraction (83) étant formées respectivement en vis-à-vis des parties d'extrémité desdits dispositifs de retenue pour ruban (80, 81).

2. Appareil d'alimentation en composants électroniques du type puce selon la revendication 1, caractérisé en ce que des leviers d'entraînement (56, 57) pour entraîner lesdits mécanismes d'alimentation (70, 72, 74, 75) sont disposés dans la largeur d'un groupe de composants conditionnés en ruban (5) respectif, au niveau d'une partie intermédiaire dudit châssis (40) formant corps.

3. Appareil d'alimentation en composants électroniques du type puce selon la revendication 1 ou 2, caractérisé en ce que les parties extérieures des bobines réceptrices (51, 52) sont formées pour fournir des rochets récepteurs (53, 54).

4. Appareil d'alimentation en composants électroniques du type puce selon la revendication 3, caractérisé en ce qu'un mécanisme d'entraînement (56, 57, 58, 59, 60, 61), destiné à un rochet récepteur (53, 54) constitué par le rebord d'une bobine réceptrice (51, 52), est disposé dans la largeur de ladite bobine réceptrice (51, 52).

5. Appareil d'alimentation en composants électroniques du type puce selon la revendication 1, caractérisé en ce qu'une plaque de connexion (87), destinée à des obturateurs (84, 85) destinés à ouvrir/fermer les parties ouvertes (83) des parties d'extraction de composants, est fixée audit dispositif de retenue de ruban (80, 81) au niveau de positions déviées de la largeur desdits rubans transporteurs (2) destinés auxdits composants électroniques conditionnés en ruban (1).
